# EUROPEAN PATENT APPLICATION

(11) **EP 4 682 631 A1**
(43) Date of publication of application: **21.01.2026**
(21) Application number: 25183659.9
(22) Date of filing: 18.06.2025
(51) Int. Cl.: G03F 1/62

(54) **CARBON SHEET FOR PELLICLE, PELLICLE AND METHOD FOR MANUFACTURING OF THE CARBON SHEET FOR PELLICLE**

(30) Priority: 19.07.2024 KR 20240095765; 25.03.2025 KR 20250037965
(71) Applicant: Awexome Ray, Inc., Gyeonggi-do 14056 (KR)
(72) Inventor: JEONG, Keunsoo, 05698 Seoul (KR); KIM, Young Bae, 13938 Gyeonggi-do (KR); CHOI, Jiwon, 13951 Gyeonggi-do (KR); GIHM, Se Hoon, 13555 Gyeonggi-do (KR)
(74) Representative: Murgitroyd & Company

(57) **Abstract**

Provided is a carbon sheet for pellicle that includes a bundle composed of a plurality of carbon nanotubes, and a ratio (P/D) of porosity P to linear density D ([g/km]) is in a range of 0.2 to 10, and provided is a pellicle and a method of manufacturing a carbon sheet for pellicle that is free-standing and have an excellent transmittance against UV rays.

## Description

### CROSS-REFERENCE TO RELATED APPLICATION(S)

This U.S. non-provisional application claims priority under 35 U.S.C. § 119 to Korean Patent Application No. 10-2024-0095765, filed on July 19, 2024, and Korean Patent Application No. 10-2025-0037965, filed on March 25, 2025, in the Korean Intellectual Property Office, the disclosures of which are incorporated herein in their entireties by reference.

### BACKGROUND

Example embodiments relate to a carbon sheet for pellicle, pellicle and a method of manufacturing a carbon sheet for pellicle.

Photolithography is a technique that uses a photomask pattern and light to transfer the pattern onto a substrate (for example, a wafer). In photolithography, extreme ultra-violet (EUV) is recently being applied to achieve high integration and miniaturization of semiconductors.

The pellicle is used to protect photomasks used in photolithography. The pellicle can cover one side of a photomask to prevent foreign substances from attaching to the photomask.

### SUMMARY

An aspect provides a carbon sheet for pellicle, with excellent transmittance over ultraviolet (UV) rays and that free-standing is possible, and provides pellicle and a method of manufacturing the carbon sheet for pellicle.

The technical tasks to be achieved by the present example embodiments are not limited to the technical tasks described above, and other technical tasks may be inferred from the following example embodiments by those skilled in the art.

According to an aspect, there is provided a carbon sheet for pellicle, the carbon sheet including a bundle composed of a plurality of carbon nanotubes, and a ratio (P/D) of porosity P to linear density D ([g/km]) is in a range of 0.2 to 10.

According to an example embodiment, the porosity P may be in a range of 0.5 to 0.95.

According to an example embodiment, the linear density D may be greater than 0.5 g/km and less than or equal to 2.8 g/km.

According to an example embodiment, the bundle may have a diameter that is in a range of 10 nm to 100 nm.

According to an example embodiment, one or more of the plurality of carbon nanotubes may include one or more of a single-walled carbon nanotube (SWCNT), a double-walled carbon nanotube (DWCNT) and a multi-walled carbon nanotube (MWCNT).

According to an example embodiment, the carbon sheet for pellicle may further include a metallic element.

According to an example embodiment, the carbon sheet for pellicle may further include elemental sulfur (S).

According to another aspect, there is provided a pellicle for protecting a photomask, the pellicle including a carbon sheet including a bundle composed of a plurality of carbon nanotubes and a pellicle frame configured to support the carbon sheet, and the carbon sheet has a ratio (P/D) of porosity P to linear density D ([g/km]) that is in a range of 0.2 to 10.

According to an example embodiment, the carbon sheet is one of a plurality of carbon sheets, the plurality of carbon sheets are stacked.

According to another aspect, there is provided a method of manufacturing a carbon sheet for pellicle, the method including forming a bundle composed of a plurality of carbon nanotubes by reacting a source material including a carbon source, and the carbon sheet for pellicle includes a bundle composed of the plurality of carbon nanotubes and the carbon sheet has a ratio (P/D) of porosity P to linear density D ([g/km]) that is in a range of 0.2 to 10.

According to an example embodiment, the source material may further include a catalyst including a metallic element and a catalyst activator including elemental sulfur (S).

According to an example embodiment, the method may further include reacting the source material at a reaction temperature of 500 °C to 2,000 °C.

According to an example embodiment, the method may further include introducing the source material into a reaction area of a reaction chamber to cause a reaction, and a flow rate at which the source material is introduced into the reaction area may exceed 15 g/h and may be 30 g/h or less.

According to an example embodiment, the method may further include making a temperature of the reaction area to be the reaction temperature before the source material is introduced into the reaction area of the reaction chamber.

According to an example embodiment, the method may further include, after making the temperature of the reaction area to be the reaction temperature before the source material is introduced into the reaction area of the reaction chamber, introducing gas into the reaction area.

Additional aspects of example embodiments will be set forth in part in the description which follows and, in part, will be apparent from the description, or may be learned by practice of the disclosure.

According to example embodiments, it is possible to provide a carbon sheet for pellicle, with excellent transmittance over ultraviolet (UV) rays and that free-standing is possible, and provide a pellicle and a method of manufacturing the carbon sheet for pellicle.

### BRIEF DESCRIPTION OF THE DRAWINGS

The drawings illustrated in the present disclosure are according to mere example embodiments, and the ratio of the width, the length and the height (or the thickness) of each element is for detailed descriptions for the example embodiments, and thus the ratio may differ from reality.

These and/or other aspects, features, and advantages of the invention will become apparent and more readily appreciated from the following description of example embodiments, taken in conjunction with the accompanying drawings of which:
FIG. 1 is a drawing illustrating a pellicle for a photomask according to an example embodiment and for explaining UV lithography technology;
FIG. 2 shows images of carbon sheets manufactured in example embodiment 1, example embodiment 2, and comparative example embodiment 1 (microscope magnification: ×30,000, scale bar size: 2 *µ*m), the images taken by a scanning electron microscope (SEM); and
FIG. 3 shows images that the images of FIG. 2 are binary imaged (microscope magnification: ×30,000, scale bar size: 2 *µ*m).

### DETAILED DESCRIPTION

Prior to the detailed description of the present disclosure, terms or words used in the specification and claims may not be construed as limited to their common or dictionary meanings. Further, the terms or words should be interpreted with meaning and concept consistent with the technical idea of the present disclosure based on the principle that the inventor may appropriately define the concept of terms in order to explain his or her invention in the best way. The example embodiments described in this specification and the configurations shown in the drawings are only the most preferred embodiments of the present disclosure, and do not necessarily represent the entire technical idea of the present disclosure. Accordingly, at the time of filing the present disclosure, there may be various equivalents and modifications that can replace them.

The same reference numeral or sign shown in each drawing attached to the specification may represent parts or components that perform substantially the same function. For convenience of description and understanding, different embodiments may be described using the same reference numerals or symbols. In other words, even if a component or an element having the same reference numeral is shown in multiple drawings, the multiple drawings may not all represent one example embodiment.

In the following description, singular expressions include plural expressions unless the context clearly dictates otherwise. It will be understood that, when an element (for example, a first element) is "(operatively or communicatively) coupled with/to" or "connected to" another element (for example, a second element), the element may be directly coupled with/to another element, and there may be an intervening element (for example, a third element) between the element and another element. The terms "have," "may have," "include," and "may include" as used herein indicate the presence of corresponding features (for example, elements such as numerical values, functions, operations, or parts), and do not preclude the presence of additional features.

Further, in the following description, expressions such as upper side, upper surface, lower side, lower surface, side, a front side and a back side are expressed based on the direction shown in the drawing. If the direction of the object changes, it may be expressed differently. Other similar expressions describing the positional relationship between elements can also be interpreted similarly as above.

Further, in the specification and claims, terms including ordinal numbers such as "first," "second," etc. may be used to distinguish between components or elements. These ordinal numbers are used to distinguish identical or similar components from each other, and the meaning of the terms should not be interpreted limitedly due to the use of such ordinal numbers. For example, components or elements combined with these ordinal numbers should not be interpreted as having a limited order of use or arrangement based on the number. If necessary, each ordinal number may be used interchangeably.

The term room temperature as used in the present disclosure is the natural temperature that has not been heated or cooled. For example, the room temperature is any temperature within the range of 10 °C to 30 °C. For example, the room temperature may indicate about 15 °C or higher, about 18 °C or higher, about 20 °C or higher, about 23 °C or higher, about 27 °C or lower, or 25 °C. In the present disclosure, unless otherwise specified, the unit of temperature is Celsius (°C). Further, among the material properties described in the present disclosure, if the measurement temperature affects the material property, unless otherwise specified, the material properties may be measured at 25 °C.

In the present disclosure, the term atmospheric pressure used may indicate natural pressure that is neither pressurized nor depressurized, and may typically indicate a pressure of about 700 mmHg to 800 mmHg. In the present disclosure, unless otherwise specified, a unit of pressure may be mmHg. Further, among the material properties described in the present disclosure, if the measurement pressure affects the material properties, unless otherwise specified, the material properties may be measured at atmospheric pressure.

In the present disclosure, the material properties described may have units according to the international system of units (SI) unless otherwise specified.

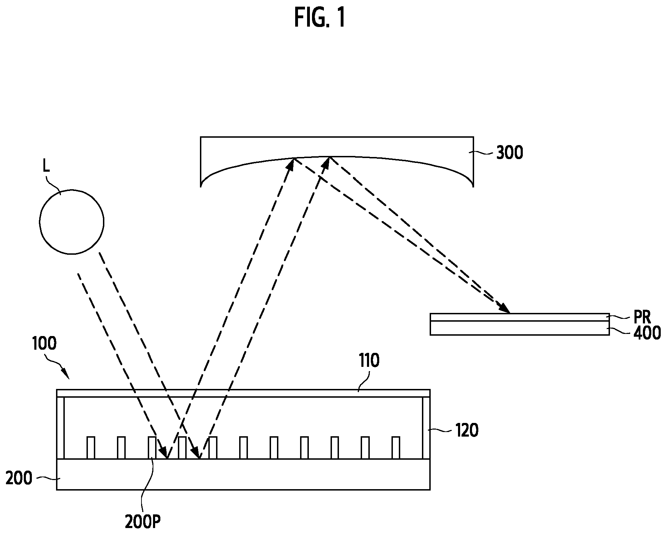

FIG. 1 is a drawing illustrating pellicle 100 according to an example embodiment and for explaining the UV lithography technology. For example, the pellicle 100 may be used for photomasks. The UV lithography technology includes irradiating UV rays generated from a light source L onto a photomask 200 and focusing the UV rays reflected from the photomask 200 onto a substrate 400 coated with a photoresist PR through lens 300 to transferring a mask pattern 200P of the photomask 200 to the photoresist PR.

In an example embodiment, there may be a foreign material attached to the photomask 200 and in this case, the UV rays are partially absorbed or scattered by the foreign material, interfering with the transfer of the mask pattern 200P, and as a result, the production yield of semiconductor chips may decrease. Specifically, since the UV rays are used, the mask pattern 200P may be formed more finely, and even if the size of the foreign material is small, the foreign material may directly affect the production yield of semiconductor chips.

In an example embodiment, the UV ray may indicate light with a wavelength of 10 nm or greater and 400 nm or less. In an example embodiment, the UV ray may indicate EUV. For example, the EUV may indicate light with a wavelength of 121 nm or less, and specifically, the EUV may indicate light with a wavelength of 10 nm or greater and 121 nm or less. In an example embodiment, the wavelength of the EUV may be 13.5 nm. Further, in the present disclosure, among the material properties described, if the wavelength of UV ray affects the material property, unless otherwise specified, the material properties may be measured with EUV having a wavelength of 13.5 nm.

The pellicle 100 according to an example embodiment may be intended to protect the above-described photomask 200. In other words, the photomask 200 may prevent a decline in the production yield of semiconductor chips by preventing foreign substances from attaching to the mask pattern 200P through the pellicle 100.

In an example embodiment, the pellicle 100 may be spaced apart from the photomask 200 by a predetermined distance based on the first direction D1, which is perpendicular to the surface of a carbon sheet 110 described later. The separation distance between the pellicle 100 and the photomask 200 may be, for example, 15 nm or less, and may be between 1 nm or greater and 10 nm or less.

In an example embodiment, the pellicle 100 may have a transmittance of 80% or greater, 85% or greater or 90% or greater to UV rays. In an example embodiment, the pellicle 100 may have a transmittance of 80% or greater, 85% or greater, or 90% or greater for light having a wavelength of 13.5 nm. In the present disclosure, the transmittance may be expressed as the percentage ratio of the radiant flux (e.g., unit: W) of light after transmitting through the pellicle 100 compared to the radiant flux of light before transmitting through the pellicle 100. The pellicle 100 may have an excellent transmittance for EUV through carbon sheet which will be described later.

The transmittance of the pellicle 100 for a specific wavelength may specifically indicate the transmittance of the carbon sheet 110 for a specific wavelength, which will be described later. In other words, the carbon sheet 110 may have a transmittance of 80% or greater, 85% or greater or 90% or greater to UV rays, and may have a transmittance of 80% or greater, 85% or greater, or 90% or greater for light having a wavelength of 13.5 nm.

The pellicle 100 according to an example embodiment may include the carbon sheet 110 which is transparent to UV rays. In an example embodiment, the carbon sheet 110 may include a bundle composed of a plurality of carbon nanotubes. In an example embodiment, the carbon sheet 110 may be in the form of a thin film. The carbon sheet 110 may be used for the pellicle 100.

In an example embodiment, the pellicle 100 may include a pellicle frame 120 supporting the carbon sheet 110. In an example embodiment, the pellicle frame 120 is placed on the edge of the carbon sheet 110 and may support the carbon sheet 110. The pellicle frame 120 may be configured to separate the carbon sheet 110 from the photomask 200 by a predetermined distance. In an example embodiment, when viewed in the first direction D1 perpendicular to the surface of the carbon sheet 110, the pellicle frame 120 may have a square or circular frame structure. The pellicle frame 120 may preferably have the same shape as the carbon sheet 110.

In an example embodiment, by including the carbon sheet 110 including a bundle composed of carbon nanotubes, the pellicle 100 may be free-standing and have an excellent transmittance to UV rays.

In an example embodiment, the carbon sheet 110 may have a ratio (P/D) of porosity P to linear density D ([g/km]) that is 0.2 or greater, 0.21 or greater, 0.22 or greater, 0.23 or greater, 0.24 or greater, 0.25 or greater, 0.26 or greater, 0.27 or greater, 0.28 or greater, 0.29 or greater, 0.3 or greater, 0.31 or greater, 0.32 or greater, 0.33 or greater, or 0.34 or greater, or 10 or less, 9.5 or less, 9 or less, 8.5 or less, 8 or less, 7.5 or less, 7 or less, 6.5 or less, 6 or less, 5.5 or less, 5 or less, 4.5 or less, 4 or less, 3.5 or less, 3 or less, 2.5 or less, 2 or less, or 1.5 or less. The carbon sheet 110 may have the ratio (P/D) of porosity P to linear density D ([g/km]) that is within the range formed by selecting the upper and lower limits described above.

In an example embodiment, the carbon sheet 110 may be free-standing. Meanwhile, when the ratio (P/D) of porosity P to linear density D ([g/km]) of the carbon sheet 110 satisfies the above-described range, the carbon sheet 110 may be free-standing and have an excellent transmittance to UV rays.

In an example embodiment, the carbon sheet 110 may have a porosity P of 0.5 or greater, 0.51 or greater, 0.52 or greater, 0.53 or greater, 0.54 or greater, 0.55 or greater, 0.56 or greater, 0.57 or greater, 0.58 or greater, 0.59 or greater, 0.6 or greater, or 0.61 or greater, 0.95 or less, 0.94 or less, 0.93 or less, 0.92 or less, 0.91 or less or 0.9 or less. The carbon sheet 110 may be within the range formed by selecting the upper and lower limits of porosity P described above. When the porosity P of the carbon sheet 110 satisfies the above-described range, the carbon sheet 110 may be free-standing and have an excellent transmittance to UV rays. In the present disclosure, the porosity P may be measured by generating a photographed image that the carbon sheet 110 is taken by the SEM, by converting the generated captured image into a binary image (for example, using the Otsu's method) and by the light-dark distribution of the binary image. In the method where the porosity P is measured as a light-dark distribution of the binary image, a computer program (for example, Calporosity_AXR) may be utilized.

In an example embodiment, the linear density D of the carbon sheet 110 may exceed 0.5 g/km, may be 0.51 g/km or greater, 0.52 g/km or greater, 0.53 g/km or greater, 0.54 g/km or greater, 0.55 g/km or greater, 0.56 g/km or greater, 0.57 g/km or greater, 0.58 g/km or greater, 0.59 g/km or greater, 0.6 g/km or greater, 0.61 g/km or greater, 0.62 g/km or greater, 0.63 g/km or greater, 0.64 g/km or greater, 0.65 g/km or greater, 0.66 g/km or greater, or 2.8 g/km or less, 2.75 g/km or less, 2.7 g/km or less, 2.65 g/km or less, 2.6 g/km or less, 2.55 g/km or less, 2.5 g/km or less, 2.45 g/km or less, 2.4 g/km or less, 2.35 g/km or less, 2.3 g/km or less, 2.25 g/km or less, 2.2 g/km or less, 2.15 g/km or less, 2.1 g/km or less, 2.05 g/km or less, 2 g/km or less, 1.95 g/km or less, 1.9 g/km or less, 1.85 g/km or less, or 1.8 g/km or less. The carbon sheet 110 may have the linear density D that is within the range formed by selecting the upper and lower limits described above. When the linear density D of the carbon sheet 110 satisfies the above-described range, the carbon sheet 110 may be free-standing and have an excellent transmittance to UV rays. In the present disclosure, the linear density may be measured according to, for example, KS K ISO 7211-2.

In an example embodiment, the diameter of the bundle may be 10 nm or greater, 15 nm or greater, 20 nm or greater, 25 nm or greater, 30 nm or greater, 35 nm or greater, 40 nm or greater, 45 nm or greater, 50 nm or greater, or 100 nm or less, 95 nm or less, 90 nm or less, 85 nm or less, 80 nm or less, 75 nm or less, 70 nm or less, or 65 nm or less. The diameter of the bundle may exist within a range formed by selecting the upper and lower limits described above. When the diameter of the bundle satisfies the above-described range, the carbon sheet 110 may be formed that is free-standing and have excellent transmittance to UV rays. For example, the diameter of a bundle may be the arithmetic mean of the diameters of 100 or more bundles.

In an example embodiment, the carbon sheet 110 may include a plurality of carbon nanotubes. The diameter of at least some of the plurality of carbon nanotubes may be less than 10 nm, 9.5 nm or less, 9 nm or less, 8.5 nm or less, 8 nm or less, 7.5 nm or less, 7 nm or less, 6.5 nm or less, 6 nm or less, 5.5 nm or less, 5 nm or less, 4.5 nm or less, 4 nm or less, 3.5 nm or less, 3 nm or less, 2.5 nm or less, 2 nm or less, 1.5 nm or less, or 1 nm or less. For example, the diameter of the carbon nanotube may be 0.1 nm or greater, but the diameter is not limited thereto. The carbon sheet 110 including the plurality of carbon nanotubes may be helpful for the carbon sheet 110 to be free-standing and to have excellent transmittance to UV rays. In an example embodiment, the weight ratio of the bundle in the carbon sheet 110 may be greater than the weight ratio of the carbon nanotube in the carbon sheet 110.

In an example embodiment, at least some of the plurality of carbon nanotubes may include one or more of single-walled carbon nanotubes (SWCNTs), double-walled carbon nanotubes (DWCNTs) and multi-walled carbon nanotubes (MWCNTs).

In an example embodiment, the carbon sheet 110 may include carbon-based materials in addition to carbon nanotubes. For example, the carbon-based material may include one or more of graphene, graphene oxide, fullerene and amorphous carbon, but the carbon-based material is not limited thereto. By including the carbon-based materials, the carbon sheet 110 may have durability against heat generated by high-energy UV rays and minimize deterioration caused by UV rays exposure. The carbon-based materials may include defects, and the defect may include one or more of sp³ carbon atoms, oxygen atoms, nitrogen atoms, and carbon vacancies. Further, the defects may take various forms, for example, line defects such as grain boundaries, and point boundaries.

In an example embodiment, the carbon sheet 110 may include metallic elements. For example, the metallic elements may include one or more of iron (Fe), molybdenum (Mo), titanium (Ti), rubidium (Ru), copper (Cu), aluminum (Al), gold (Au), platinum (Pt) and silver (Ag), but the metallic elements are not limited thereto. The metallic elements may exist in a pure substance state, and may exist in a compound state, such as a metal oxide, metal nitride, and metal chalcogenide-based substance. The types of compound of the metallic elements are not limited thereto. More specifically, metal oxides and metal nitrides may include, for example, iron oxide, molybdenum oxide, molybdenum nitride or titanium nitride. The metal chalcogenide-based materials may include, for example, transition metal chalcogenides. By including the metallic element, the carbon sheet 110 may have the durability against heat generated by UV rays and minimize deterioration caused by UV rays exposure. Further, by the carbon sheet 110 including the metallic element, the transmittance to UV rays may be increased.

In an example embodiment, the carbon sheet 110 may include elemental sulfur (S). By including the elemental sulfur, the carbon sheet 110 may have the durability against heat generated by UV rays and minimize deterioration caused by UV rays exposure. Further, by the carbon sheet 110 including the elemental sulfur, the transmittance to UV rays may be increased.

In an example embodiment, the pellicle 100 may include a plurality of carbon sheets. The plurality of carbon sheets may be stacked. Even if the plurality of carbon sheets are stacked, the above-mentioned material properties of each carbon sheet 110 and the stacked plurality of carbon sheets may be satisfied. Through this, the pellicle 100 may be free-standing and have an excellent transmittance to UV rays.

In an example embodiment, the plurality of carbon sheets may be stacked to include, for example, two or more, three or more, four or more, or hundred or fewer, fifty or fewer, or ten or fewer the carbon sheets.

In an example embodiment, the carbon sheet 110 may have a thermal decomposition temperature of 800 °C or higher. In an example embodiment, the thermal decomposition temperature of the carbon sheet 110 may be 850 °C or higher, 900 °C or higher, 950 °C or higher, 1,000 °C or higher, 1,050 °C or higher, 1,100 °C or higher, 1,150 °C or higher, or 1,200 °C or higher. The upper temperature limit of thermal decomposition of the carbon sheet 110 is not specifically limited, but the upper temperature limit may be, for example, 2,000 °C or lower, 1,950 °C or lower, 1,900 °C or lower, 1,850 °C or lower, 1,800 °C or lower, 1,750 °C or lower, 1,700 °C or lower, 1,650 °C or lower, 1,600 °C or lower, 1,550 °C or lower, 1,500 °C or lower, 1,450 °C or lower, or 1,400 °C or lower. The thermal decomposition temperature of the carbon sheet 110 may be within a range formed by selecting the upper and lower limits described above. The carbon sheet 110 may have the thermal decomposition temperature described above by including a bundle composed of the above-described plurality of carbon nanotubes. In the present disclosure, the thermal decomposition temperature may indicate the temperature when the weight reduction rate is about 20% (in other words, the residual weight is 80%) when thermogravimetric analysis is performed in an air atmosphere.

In an example embodiment, the thickness of the carbon sheet 110 may be determined based on the ratio (P/D) of porosity P to the above-described linear density D ([g/km]). For example, the thickness of the carbon sheet 110 may be 100 nm or less. In an example embodiment, the thickness of the carbon sheet 110 may be 70 nm or less or 50 nm or less. There is no particular limitation on the thickness of the carbon sheet 110 as long as the carbon sheet 110 has excellent durability, a high transmittance to UV rays and is free-standing. For example, the thickness of the carbon sheet 110 may be 10 nm or greater, 20 nm or greater, 30 nm or greater, or 40 nm or greater.

In an example embodiment, of the total weight, the carbon sheet 110 may include bundles of 80 wt% or greater, 81 wt% or greater, 82 wt% or greater, 83 wt% or greater, 84 wt% or greater, 85 wt% or greater, 86 wt% or greater, 87 wt% or greater, 88 wt% or greater, 89 wt% or greater, 90 wt% or greater, 91 wt% or greater, 92 wt% or greater, or 93 wt% or greater. The higher the weight ratio of the bundle included in the carbon sheet 110, the better the optical properties such as transmittance to UV rays may be. Thus, even though the carbon sheet 110 is not specifically limited, of the total weight, the carbon sheet 110 may include bundles of 100 wt% less, 99 wt% or less, 98 wt% or less, 97 wt% or less, 96 wt% or less, or 95 wt% or less. The carbon sheet 110 may include bundles within the range formed by selecting the upper and lower limits described above. Through this, the carbon sheet 110 may be free-standing and have an excellent transmittance to UV rays.

In an example embodiment, of the total weight, the carbon sheet 110 may include carbon element (C) of 60 wt% or greater, 65 wt% or greater, 70 wt% or greater, 75 wt% or greater, 80 wt% or greater, 85 wt% or greater, 90 wt% or greater, 95 wt% or greater, 99 wt% or greater, or 99.9 wt% or greater. The upper limit of the weight ratio of carbon element (C) included in the carbon sheet 110 is not specifically limited, but, of the total weight, the carbon sheet 110 may include carbon element (C) of 100 wt% or less, less than 100 wt%, or 99.99 wt% or less. The carbon sheet 110 may include carbon element (C) within a range formed by selecting the upper and lower limits described above. Through this, the carbon sheet 110 may be free-standing and have an excellent transmittance to UV rays.

In an example embodiment, of the total weight, the carbon sheet 110 may include a metallic element of 1 wt% or greater, 1.5 wt% or greater, 2 wt% or greater, 2.5 wt% or greater, 3 wt% or greater, 3.5 wt% or greater, 4 wt% or greater, 4.5 wt% or greater, or 5 wt% or greater, or may include a metallic element of 15 wt% or less, 14.5 wt% or less, 14 wt% or less, 13.5 wt% or less, 13 wt% or less, 12.5 wt% or less, 12 wt% or less, 11.5 wt% or less, 11 wt% or less, 10.5 wt% or less, 10 wt% or less, 9.5 wt% or less, 9 wt% or less, 8.5 wt% or less, 8 wt% or less, 7.5 wt% or less, 7 wt% or less, 6.5 wt% or less, or 6 wt% or less. The carbon sheet 110 may include the metallic element within a range formed by selecting the upper and lower limits described above. Through this, the carbon sheet 110 may be free-standing and have an excellent transmittance to UV rays.

In an example embodiment, of the total weight, the carbon sheet 110 may include elemental sulfur of 0.01 wt% or greater, 0.05 wt% or greater, 0.1 wt% or greater, 0.15 wt% or greater, 0.2 wt% or greater, 0.25 wt% or greater, or 0.3 wt% or greater, or may include elemental sulfur of 1 wt% or less, 0.9 wt% or less, 0.8 wt% or less, 0.7 wt% or less, 0.6 wt% or less, 0.5 wt% or less, or 0.4 wt% or less. The carbon sheet 110 may include elemental sulfur within a range formed by selecting the upper and lower limits described above. Through this, the carbon sheet 110 may be free-standing and have an excellent transmittance to UV rays.

In an example embodiment, a method of manufacturing the carbon sheet 110 may include reacting a source material. The method of manufacturing the carbon sheet 110 may be, for example, a method for manufacturing the carbon sheet 110 for pellicle. The method of manufacturing the carbon sheet 110 may include reacting a source material to form a bundle including a plurality of carbon nanotubes. For the features regarding the carbon sheet 110, the above descriptions may be referred.

In an example embodiment, the method of manufacturing the carbon sheet 110 may include reacting a source material at a reaction temperature to form a bundle including a plurality of carbon nanotubes. In the present disclosure, unless otherwise specified, the reaction temperature may indicate the temperature at which the source material may react to form the carbon sheet 110 including a bundle composed of a plurality of carbon nanotubes.

In an example embodiment, the reaction temperature may be 500 °C or higher, 550 °C or higher, 600 °C or higher, 650 °C or higher, 700 °C or higher, 750 °C or higher, 800 °C or higher, 850 °C or higher, 900 °C or higher, 950 °C or higher, 1,000 °C or higher, or 2,000 °C or less, 1,900 °C or less, 1,800 °C or less, 1,700 °C or less, 1,600 °C or less, 1,500 °C or less, 1,400 °C or less, 1,300 °C or less, 1,200 °C or less, 1,100 °C or less. The reaction temperature may be within a range formed by appropriately selecting the upper and lower limits described above. In other words, the method of manufacturing the carbon sheet 110 may include reacting the source material at a reaction temperature within the range described above. Through this, the carbon sheet 110 having the material properties described above may be formed from the source material.

In an example embodiment, the method of manufacturing the carbon sheet 110 may include introducing a source material into a reaction area of a reaction chamber and causing a reaction. In other words, the source material may be introduced into the reaction area of the reaction chamber and reacted. Here, the reaction chamber may include a heater, and be configured to have the reaction area reach the reaction temperature through the heater. Although not particularly limited, the method of manufacturing the carbon sheet 110 may include bringing the temperature of the reaction area to a reaction temperature prior to introducing the source material into the reaction area of the reaction chamber. Through this, the carbon sheet 110 having the material properties described above may be formed from the source material.

In an example embodiment, the flow rate at which source material is introduced into the reaction area of the reaction chamber may exceed 15 g/h, may be 15.5 g/h or higher, 16 g/h or higher, 16.5 g/h or higher, 17 g/h or higher, 17.5 g/h or higher, 18 g/h or higher, 18.5 g/h or higher, 19 g/h or higher, or 30 g/h or less, 29 g/h or less, 28 g/h or less, 27 g/h or less, 26 g/h or less, 25 g/h or less, 24 g/h or less, or 23 g/h or less. The flow rate at which the source material is introduced into the reaction area of the reaction chamber may be within a range formed by appropriately selecting the upper and lower limits described above. Through this, the carbon sheet 110 having the material properties described above may be formed from the source material.

In an example embodiment, the method of manufacturing the carbon sheet 110 may include introducing gas into the reaction area after raising the temperature of the reaction area to a reaction temperature before introducing the source material into the reaction area of the reaction chamber. Through this, side reactions of the source material may be minimized. The gas introduced into the reaction area may include, for example, hydrogen (H₂) and inert gases (for example, a gas including elements of group 18 of the periodic table, such as argon (Ar)).

In an example embodiment, the source material may include a carbon source. The carbon source may include a carbon compound that is liquid or gaseous at room temperature and atmospheric pressure. For example, the carbon source may include one or more of an alkane, an alkene, an alkyne, an alcohol and a ketone. The alkane may include, for example, one or more of methane, ethane, butane, propane and hexane. The alkene may include, for example, one or more of ethylene, propylene and butylene. The alkyne may include, for example, one or more of acetylene, methylacetylene and vinylacetylene. The alcohol may include, for example, one or more of methanol, ethanol, isopropyl alcohol, butanol, pentanol, cetyl alcohol, ethylene glycol, propylene glycol, glycerol, erythritol, xylitol, sorbitol, bolemitol, allyl alcohol, geraniol, propargyl alcohol, inositol and menthol. The ketone may include one or more of, for example, acetone and dimethyl ketone. However, these are mere examples and the carbon source is not limited thereto.

In an example embodiment, the source material may include a catalyst. For example, the catalyst may include a metallic element. The catalyst may include a metallocene. The metallocene may include a central metal and an organic ligand. The central metal may be the metallic element included in the catalyst. For example, the central metal may include one or more of iron (Fe), molybdenum (Mo), titanium (Ti), rubidium (Ru), copper (Cu), aluminum (Al), gold (Au), platinum (Pt) and silver (Ag). For example, the organic ligand may include one or more of a cyclopentadienyl group, a methylcyclopentadienyl group, a pentamethylcyclopentadienyl group, an indenyl group and a fluorenyl group. For example, metallocene may include ferrocene, which includes iron (Fe).

In an example embodiment, the source material may include a catalyst activator capable of lowering the activation temperature of the catalyst. For example, the catalyst activator may include the element sulfur (S). The catalyst activator may include thiophene.

In an example embodiment, of the total weight, the source material may include carbon element (C) of 60 wt% or greater, 65 wt% or greater, 70 wt% or greater, 75 wt% or greater, 80 wt% or greater, 85 wt% or greater, 90 wt% or greater, 95 wt% or greater, 99 wt% or greater, or 99.9 wt% or greater. The upper limit of the weight ratio of carbon element (C) included in the source material is not specifically limited. However, of the total weight, the source material may include carbon element (C) of 100 wt% or less, less than 100 wt%, or 99.99 wt% or less. The source material may include carbon element (C) within a range formed by selecting the upper and lower limits described above. Through this, manufactured may be the carbon sheet 110 having an excellent transmittance to UV rays and being free-standing.

In an example embodiment, of the total weight, the source material may include a metallic element of 1 wt% or greater, 1.5 wt% or greater, 2 wt% or greater, 2.5 wt% or greater, 3 wt% or greater, 3.5 wt% or greater, 4 wt% or greater, 4.5 wt% or greater or 5 wt% or greater, or 15 wt% or less, 14.5 wt% or less, 14 wt% or less, 13.5 wt% or less, 13 wt% or less, 12.5 wt% or less, 12 wt% or less, 11.5 wt% or less, 11 wt% or less, 10.5 wt% or less, 10 wt% or less, 9.5 wt% or less, 9 wt% or less, 8.5 wt% or less, 8 wt% or less, 7.5 wt% or less, 7 wt% or less, 6.5 wt% or less, or 6 wt% or less. The source material may include the metallic element within a range formed by selecting the upper and lower limits described above. Through this, manufactured may be the carbon sheet 110 having an excellent transmittance to UV rays and being free-standing.

In an example embodiment, of the total weight, the source material may include elemental sulfur of 0.01 wt% or greater, 0.05 wt% or greater, 0.1 wt% or greater, 0.15 wt% or greater, 0.2 wt% or greater, 0.25 wt% or greater or 0.3 wt% or greater, or 1 wt% or less, 0.9 wt% or less, 0.8 wt% or less, 0.7 wt% or less, 0.6 wt% or less, 0.5 wt% or less, or 0.4 wt% or less. The source material may include elemental sulfur within a range formed by selecting the upper and lower limits described above. Through this, manufactured may be the carbon sheet 110 having an excellent transmittance to UV rays and being free-standing.

In an example embodiment, the source material may include metallic element (M) and elemental sulfur (S). The weight ratio (M/S) of metallic element (M) to elemental sulfur (S) may be 1 or greater, 2 or greater, 3 or greater, 4 or greater, 5 or greater, 6 or greater, 7 or greater, 8 or greater, 9 or greater, 10 or greater, 11 or greater, 12 or greater, 13 or greater, 14 or greater, 15 or greater, or 50 or less, 45 or less, 40 or less, 35 or less, 30 or less, 25 or less, or 20 or less. The weight ratio (M/S) of metallic element (M) to elemental sulfur (S) included in the source material may be included within a range formed by selecting the upper and lower limits described above. Through this, manufactured may be the carbon sheet 110 having an excellent transmittance to UV rays and being free-standing.

In an example embodiment, the source material may include elemental sulfur (S) and carbon element (C). The weight ratio (S/C) of elemental sulfur (S) to carbon element (C) may be 0.0001 or greater, 0.0005 or greater, 0.001 or greater, 0.0015 or greater, 0.002 or greater, 0.0025 or greater, 0.003 or greater, 0.0035 or greater or 0.004 or greater, or 0.1 or less, 0.05 or less, or 0.01 or less. The weight ratio (S/C) of elemental sulfur (S) to carbon element (C) included in the source material may be included within a range formed by selecting the upper and lower limits described above. Through this, manufactured may be the carbon sheet 110 having an excellent transmittance to UV rays and being free-standing.

In an example embodiment, the method of manufacturing the pellicle 100 may include manufacturing the carbon sheet 110. In an example embodiment, for the manufacturing the carbon sheet 110, the manufacturing method of the carbon sheet 110 described above may be referred to. In an example embodiment, the manufacturing the pellicle 100 may include bonding the carbon sheet 110 to the pellicle frame 120. In order for the pellicle frame 120 to be placed on the edge of the carbon sheet 110 to support the carbon sheet 110, the carbon sheet 110 may be bonded to the pellicle frame 120.

Below, example embodiments of the present disclosure are further described with reference to specific examples. The example embodiments and comparative example embodiments are merely illustrative of the present disclosure, and do not limit the scope of the claims. It is apparent to those skilled in the art that various changes and modifications to the example embodiments are possible within the scope and technical idea of the present disclosure. Further, it is also to be understood that such modifications and variations fall within the scope of the appended claims.

### Example embodiment 1.

The reaction chamber was heated in order for the temperature in the reaction area to be approximately 1,200 °C, and gas including hydrogen (H₂) and argon (Ar) was introduced into the reaction area for hours while maintaining the temperature of the reaction area. After then, while maintaining the temperature of the reaction area, source material including ferrocene, acetone, and sulfur-including catalyst activator was introduced into the reaction area to manufacture the carbon sheet 110 including a bundle composed of carbon nanotubes. The source material had a weight ratio (Fe/S) of iron element (Fe) to elemental sulfur (S) of approximately 17, and the weight ratio (S/C) of elemental sulfur (S) to carbon element (C) was approximately 0.004. The carbon sheet 110 included about 94 wt% of the bundle compared to the total weight, and included about 94 wt% of carbon (C) element compared to the total weight. The flow rate at which the source material was introduced into the reaction area was approximately 19.2 g/h.

### Example embodiment 2.

The carbon sheet 110 was manufactured in the same manner as in example embodiment 1 described above except that the source material input flow rate was approximately 23 g/h.

### Comparative example embodiment 1.

The carbon sheet was manufactured in the same manner as in example embodiment 1 described above except that the source material input flow rate was approximately 31.2 g/h.

### Comparative example embodiment 2.

The carbon sheet was manufactured in the same manner as in example embodiment 1 described above except that the source material input flow rate was approximately 15 g/h.

### Experimental example 1_porosity measurement

The carbon sheet 110 manufactured in the example embodiment and the carbon sheet 110 manufactured in the comparative example embodiment were produced as unit samples. The unit sample images are obtained by taking images using the SEM, and the images are converted into binary images using a computer program (Calporosity _AXR) to measure porosity by light-dark distribution of the binary images.

### Experimental example 2_linear density measurement

The carbon sheet 110 manufactured in the example embodiment and the carbon sheet 110 manufactured in the comparative example embodiment were produced as unit samples. The weight per km of fiber was calculated by placing the unit sample in water and fiberizing it to measure the linear density (unit: g/km).

### Experimental example 3_transmittance measurement

The carbon sheet 110 manufactured in the example embodiment and the carbon sheet 110 manufactured in the comparative example embodiment were produced as unit samples. The transmittance was measured by irradiating a unit sample with light having a wavelength of approximately 13.5 nm in the direction of the thickness of the unit sample, and by expressing the ratio of the radiant flux (unit: W) of light transmitted through the unit sample to the radiant flux (unit: W) of the light irradiated on the unit sample in the percentage.

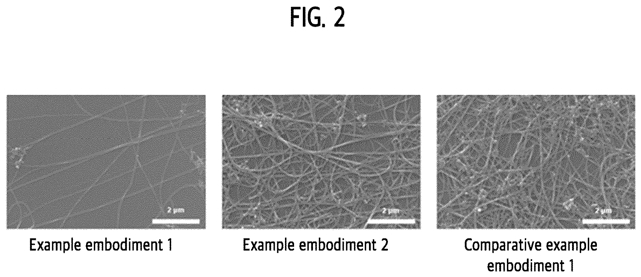

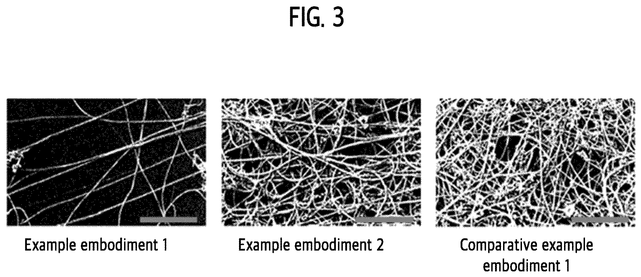

The material properties of the carbon sheet manufactured in the above-described example embodiment and the carbon sheet manufactured in the comparative example embodiment are summarized in Table 1, FIG. 2, and FIG. 3 below. FIG. 2 shows SEM-taken images of a carbon sheet manufactured in example embodiment 1, a carbon sheet manufactured in example embodiment 2, and a carbon sheet manufactured in comparative example embodiment 1. FIG. 3 shows images that are binary image-processed for FIG. 2.

**[Table 1]**

| | Example embodiment 1 | Example embodiment 2 | Comparative example embodiment 1 | Comparative example embodiment 2 |
|---|---|---|---|---|
| Whether free-standing or not | O | O | O | X |
| Porosity P | 0.897 | 0.614 | 0.4966 | Cannot be measured |
| Linear density D | 0.66 g/km | 1.77 g/km | 2.88 g/km | 0.5 g/km |
| Porosity P/Linear density D | 1.35 | 0.347 | 0.173 | Cannot be measured |
| Transmittance | 98.7% | 95.4% | 74.2% | Cannot be measured |

Referring to Table 1, FIG. 2 and FIG. 3, the carbon sheet manufactured in example embodiment 1, the carbon sheet manufactured in example embodiment 2, and the carbon sheet manufactured in comparative example embodiment 1 were all free-standing. However, the carbon sheet manufactured in comparative example embodiment 2, which had a relatively low linear density, was not free-standing.

Referring to Table 1, the carbon sheet manufactured in example embodiment 1 and the carbon sheet manufactured in example embodiment 2 having porosity P/linear density D within the above-described range were found to have excellent transmittances to UV rays. On the other hand, the carbon sheet manufactured in comparative example embodiment 1 having a porosity P/linear density D outside the above-described range shows the transmittance to UV rays as less than 80%.

The example embodiments of the present disclosure are described with reference to the attached drawings. However, the present disclosure is not limited to the example embodiments, and the present disclosure can be manufactured in various other forms, and a person skilled in the art to which the present disclosure pertains will understand that the present disclosure can be implemented in other specific forms without changing its technical idea or essential features. Therefore, the example embodiments described above should be understood in all respects as illustrative and not limiting.

## Claims

1. A carbon sheet for pellicle, the carbon sheet comprising a bundle composed of a plurality of carbon nanotubes,
wherein a ratio (P/D) of porosity P to linear density D ([g/km]) is in a range of 0.2 to 10.

2. The carbon sheet for pellicle of claim 1, wherein the porosity P is in a range of 0.5 to 0.95.

3. The carbon sheet for pellicle of claim 1, wherein the linear density D is greater than 0.5 g/km and less than or equal to 2.8 g/km.

4. The carbon sheet for pellicle of claim 1, wherein the bundle has a diameter that is in a range of 10 nm to 100 nm.

5. The carbon sheet for pellicle of claim 1, wherein one or more of the plurality of carbon nanotubes comprise one or more of a single-walled carbon nanotube (SWCNT), a double-walled carbon nanotube (DWCNT) and a multi-walled carbon nanotube (MWCNT).

6. The carbon sheet for pellicle of claim 1, further comprising a metallic element.

7. The carbon sheet for pellicle of claim 1, further comprising elemental sulfur (S).

8. A pellicle comprising:
a carbon sheet comprising a bundle composed of a plurality of carbon nanotubes; and
a pellicle frame configured to support the carbon sheet,
wherein the carbon sheet has a ratio (P/D) of porosity P to linear density D ([g/km]) that is in a range of 0.2 to 10.

9. The pellicle of claim 8, wherein the carbon sheet is one of a plurality of carbon sheets,
the plurality of carbon sheets are stacked.

10. A method of manufacturing a carbon sheet for pellicle, the method comprising forming a bundle composed of a plurality of carbon nanotubes by reacting a source material including a carbon source,
wherein the carbon sheet for pellicle comprises a bundle composed of the plurality of carbon nanotubes, and
wherein the carbon sheet has a ratio (P/D) of porosity P to linear density D ([g/km]) that is in a range of 0.2 to 10.

11. The method of claim 10, wherein the source material further comprises a catalyst comprising a metallic element and a catalyst activator comprising elemental sulfur (S).

12. The method of claim 10, further comprising reacting the source material at a reaction temperature of 500 °C to 2,000 °C.

13. The method of claim 12, further comprising introducing the source material into a reaction area of a reaction chamber to cause a reaction,
wherein a flow rate at which the source material is introduced into the reaction area exceeds 15 g/h and 30 g/h or less.

14. The method of claim 13, further comprising making a temperature of the reaction area to be the reaction temperature before the source material is introduced into the reaction area of the reaction chamber.

15. The method of claim 14, further comprising,
after making the temperature of the reaction area to be the reaction temperature before the source material is introduced into the reaction area of the reaction chamber, introducing gas into the reaction area.
